Europäisches Patentamt

European Patent Office

Office européen des brevets

(19)

(11) Publication number: **0 514 592 A1**

## EUROPEAN PATENT APPLICATION

(12)

(21) Application number: **91201217.6**

(22) Date of filing: **22.05.91**

(51) Int. Cl.5: **H04B 10/06**, H03G 3/20,
G08C 23/00, G08B 13/183

(43) Date of publication of application:
**25.11.92 Bulletin 92/48**

(84) Designated Contracting States:
**AT BE CH DE DK ES FR GB GR IT LI LU NL SE**

(71) Applicant: **REER S.p.A.**
**via Carcano 32**
**I-10153 Torino(IT)**

(72) Inventor: **Occhetto, Sergio**
**corso San Martino 8**
**I-10122 Torino(IT)**

(74) Representative: **Spandonari, Carlo**
**corso Re Umberto 56**
**I-10128 Torino(IT)**

(54) A detector of pulsed light signals, particularly for protection barriers and infrared remote controls.

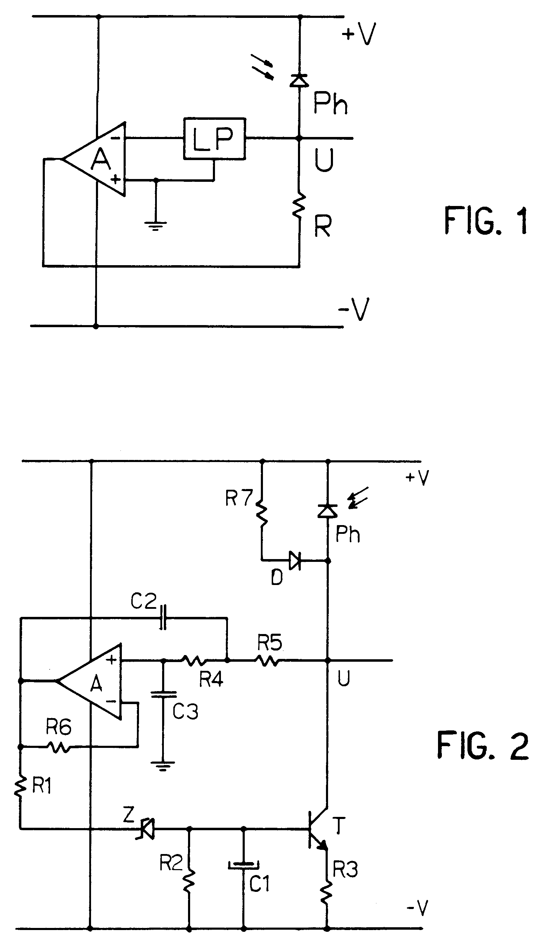

(57) The detector comprises a photodiode (Ph) powered by a direct voltage and connected in series with current regulating means (A, LP, R, Fig. 1; A, C1-C3, R1-R6, Z, T, Fig. 2) which are feedback-controlled to compensate the photodiode current components up to 100 or 120 Hz. A constant voltage is thus maintained across the photodiode when the incoming light signals have a frequency lower than 100 or 120 Hz. The current regulating means comprise circuit means for low-pass filtering and inverting amplification having an input and an output connected in a loop. The junction (U) between the photodiode and the current regulating means is the output terminal of the detector.

EP 0 514 592 A1

This invention is concerned with a detector of pulsed light signals in a background of ambient light, particularly for protection barriers (or so-called "light curtains") and infrared remote controls, having a high rejection of the influence of ambient light, be it natural or man-made.

Detection devices for infrared signals are widely used nowadays in different applications, such as remote controls for motor-actuated doors and gates, protection barriers for tool machines, etc. However, the infrared signals used in such applications must coexist with sources of substantially continuous infrared light or power, having an intensity variable within a broad range (in the order of 100,000 lux or more), and comprising both sunlight and other sources of light and heat which may be present in the operating environment and which are generally pulsing at 100 Hz or 120 Hz, due to their being powered by an alternate current at 50 Hz or 60 Hz. Moreover, the useful signal, depending on the application and on the circumstances, also varies strongly in intensity, and can be either quite weak or quite strong.

The sensitive element used in detectors of infrared signals typically is a solid-state photodiode which under the action of light, generates a current through a load resistor: the voltage arising across the photodiode is then processed in suitable amplifying and filtering circuits. The useful signal voltage therefore appears as a pulsed change overlying a substantially d.c. voltage caused by ambient light, and the subsequent amplifying and filtering circuits fulfill the task of filtering off, in so far as possible, the d.c. component of the voltage, in order to enhance its pulsed component. A final level detector is arranged to recognize the pulses.

Such known devices operate satisfactorily with low ambient light, such that the amplitude of the useful signal is considerable with respect to the d.c. voltage and consequently the task of isolating the useful signal is easy, but with high-intensity ambient light (say in open sunlight, or near big lamps or ovens, etc.) a direct voltage component (possibly modulated at 100 or 120 Hz, if the ambient light is man-made) will be superposed on the useful signal, having a considerable amplitude and in fact overshadowing the amplitude of the useful signal, so that the device will be already saturated by the ambient light alone.

In order to avoid saturation, the resistor in series to the photodiode must be chosen with a very low value. This in turn requires a high-gain, wide-band amplifier equipped with complex anti-saturation devices, in order to be able to handle high-intensity useful signals. Moreover, efficient filters must be used to reject the 100-Hz signal, in order to prevent the detector from only recognizing the signals at the peaks of the 100-Hz noise.

The problem is worsened by the consideration that in a circuit of that design the operating voltage/lighting characteristic curve of the photodiode is nonlinear, due to the decrease of the reverse voltage across the photodiode as the lighting on the photodiode increases, since the parasite capacity of the junction is also increased thereby. The voltage change caused by a given lighting step is larger if the operating point is near the origin of the characteristic (dark environment) and is less if the operating point is displaced toward farther areas in the characteristic curve (strongly lit environment).

It is therefore the main object of the invention to provide a detector of pulsed light signals, particularly infrared signals, which has a high rejection against ambient light.

The invention achieves the above and other objects and advantages, such as will appear from the following disclosure, with a detector of pulsed light signals, particularly infrared, characterized in that it comprises a photodiode powered by a source of direct voltage and connected in series with current regulating means which are feedback-controlled to compensate the photodiode current components below a predetermined threshold, so that a constant voltage is maintained across the photodiode when the incoming light signals have a frequency lower than said predetermined threshold, the junction between the photodiode and the current regulating means being the output terminal of the detector.

The invention will now be described in more detail with reference to preferred embodiments, shown in the attached drawing, which is given by way of nonlimiting example, and wherein:

Fig. 1 is a basic circuit diagram of a light signal detector device according to the invention; and

Fig. 2 is a circuit diagram of a preferred practical embodiment of a light signal detector device according to the invention.

With reference to Fig. 1, a photodiode Ph has its cathode connected to a positive supply voltage $+V$, while its anode is connected to the input of a low-pass filter LP. The output of filter LP drives the inverting input of an operational amplifier A, whose non-inverting input is grounded. The output of operational amplifier A is fed back in negative feedback to the anode of photodiode Ph through a feedback resistor R. The junction U between photodiode Ph and resistor R is the output terminal for the circuit and delivers a voltage signal $V_o$ for driving suitable downstream amplifying and processing circuits not shown.

Low-pass filter LP has a cutoff frequency intermediate between 100 Hz (or 120 Hz) and the lowest repetition rate of the pulses used for the infrared signal (typically in the order of 1000 Hz).

Its main pole is designed so that no appreciable phase errors are introduced in the 100-Hz component which is transferred to its output.

When no pulsed light signals are present, photodiode Ph is subjected only to the natural ambient light, which causes a direct current to flow in the diode, or to man-made ambient light or power, at 100 or 120 Hz as a rule, which will cause a current componente at 100 or 120 Hz to flow in the diode. In such circumstances, as known from the theory of operational amplifiers (e.g., see National Semiconductor Corporation, Linear Application Handbook, 1986, page 101 and ff.), the circuit will operate so that junction U is kept at zero voltage (junction U is a virtual ground), due to feedback resistor R, and independently of the lighting level on the photodiode.

If, on the other hand, photodiode Ph receives light pulses at a high repetition rate, filter LP will behave substantially as an open circuit in respect of them, and the negative feedback through amplifier A fails. Since the output of the amplifier is a virtual zero, the circuit reduces to a voltage divider comprising photodiode Ph and resistor R, and the current changes in the photodiode cause corresponding signal voltages on junction U, which are free from superposed direct components.

The circuit of Fig. 2 is derived from the basic diagram of Fig. 1, and includes arrangements aimed at optimizing its operation. The passive feedback loop (resistor R) of Fig. 1 is here replaced by an active network comprising a bipolar transistor T, the base of which is driven by amplifier A through a series connection of a resistor R1 and a zener Z, with a resistance-capacitance shunt R2, C1. A resistor R3 biases the emitter of transistor T. In order to compensate the inverting operation of transistor T, amplifier A is driven through its non-inverting input.

Further, filter LP is implemented as an active filter of the second rank, which incorporates amplifier A and includes resistors R3, R4 and capacitors C2, C3, arranged in a way which will be obvious for a person skilled in the art. The gain of the amplifier is limited to a unit value by a resistor R6 inserted in feeback from the output to the inverting input.

Finally, a resistor R7 is preferably connected in parallel to photodiode Ph.

Resistors R2 and R3 fulfill the task of limiting the gain of transistor T, which, if excessive, might give rise to circuit instability; R3 linearizes the performance of the transistor. Typically, bipolar transistor T should have a low $h_{fe}$ and a low $h_{oe}$ - (see Millman and Halkias, Electronic Devices and Circuits, McGraw-Hill, 1967); R2 is in the range of 1 kΩ; R3 is in the range of 100 Ω. Capacitor C1 contributes to the closed-loop filtering, by lowering the frequency of the dominant pole of the system; its value is, e.g., about 47 μF.

Replacing resistor R of Fig. 1 with transistor T of Fig. 2 considerably improves the performance of the circuit. It can be seen that the transistor has a very low static resistance, as controlled by the output of amplifier A, while it has a high dynamic impedance. This contributes to reduce the low-frequency noise, while enhancing the amplification efficiency for the high-frequency pulse signals.

Zener Z has the purpose of preventing the device from behaving abnormally in conditions of darkness. Resistor R7 also serves a similar purpose, i.e. it supplies an operating current to the transistor even in conditions of darkness. Moreover, it reduces the recovery time for the minority carriers in the photodiode after each signal pulse, and therefore speeds up its dissaturation.

Practical tests have shown that the circuit can detect pulsed signals without degradation in the presence of natural or artificial ambient light ranging from darkness to a few hundred thousand lux.

Transistor T, rather than a bipolar transistor, might be a FET transistor operating in the saturation region.

Preferred embodiments of the invention have been described, which are given by way of example and are capable of technically equivalent changes and modifications, falling within the scope of the inventive idea.

**Claims**

1.  A detector of pulsed light signals, particularly infrared, characterized in that it comprises a photodiode (Ph) powered by a source of direct voltage and connected in series with current regulating means (A, LP, R, Fig. 1; A, C1-C3, R1-R6, Z, T, Fig. 2) which are feedback-controlled to compensate the photodiode current components below a predetermined threshold, so that a constant voltage is maintained across the photodiode when the incoming light signals have a frequency lower than said predetermined threshold, the junction (U) between the photodiode and the current regulating means being the output terminal of the detector.

2.  A detector of pulsed light signals according to claim 1, characterized in that said current regulating means comprise circuit means for low-pass filtering and inverting amplification, which have an input and an output connected as a loop.

3.  A detector of pulsed light signals according to claim 2, characterized in that said circuit means for low-pass filtering and inverting amplification comprise a low-pass filter (LP, Fig. 1) driving an inverting amplifier (A, Fig. 1), and a resistor (R, Fig. 1) connecting the output of the amplifier to the input of the low-pass filter.

4. A detector of pulsed light signals according to claim 3, characterized in that said inverting amplifier is an operational amplifier (A, Fig. 1) having an inverting input connected to the output of said low-pass filter (LP, Fig. 1) and a non-inverting input connected to a fixed voltage.

5. A detector of pulsed light signals according to claim 2, characterized in that said circuit means for low-pass filtering and inverting amplification comprise an active, non-inverting low-pass filter (A, C2, C3, R4, R5, R6, Fig. 2) whose output drives a control terminal of a transistor (T, Fig. 2) and an output terminal connected to the input of said active filter.

6. A detector of pulsed light signals according to claim 5, characterized in that said active low-pass filter comprises an operational amplifier (A, Fig. 2) having an inverting input connected to the output and a network of resistors and capacitors (C2, C3, R4, R5, Fig. 2) connected to the non-inverting input and to the output of the operational amplifier so that a low-pass filtering is obtained.

7. A detector of pulsed light signals according to claim 5 or 6, characterized in that said low-pass filter is of the second rank.

8. A detector of pulsed light signals according to claim 5, 6 or 7, characterized in that a zener (Z, Fig. 2) is connected between the output of the amplifier (A, Fig. 2) and said control terminal of the transistor.

9. A detector of pulsed light signals according to any of claims 5 to 8, characterized in that said transistor (T) is a bipolar transistor, said control terminal being the base of the transistor and said output terminal being the collector of the transistor.

10. A detector of pulsed light signals according to any of claims 5 to 8, characterized in that said transistor is a FET transistor, said control terminal being the gate of the transistor and said output terminal being the drain of the transistor.

11. A detector of pulsed light signals according to claim 6, 7 or 8, characterized in that a resistor (R7, Fig. 2) is connected in parallel with said photodiode.

12. A detector of pulsed light signals according to claim 11, characterized in that a diode (D, Fig. 2) is connected in series with said resistor (R7).

13. A detector of pulsed light signals according to any of claims 1 to 12, characterized in that the cut-off frequency of said filtering is intermediate between 100 Hz and the minimum desired repetition rate of the pulsed light signals.

FIG. 1

FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | EP-A-0 140 091 (ROBERT BOSCH GMBH)<br><br>* page 4, line 25 - page 9, line 16; figures 1,2 *<br>---  | 1-6,<br>8-11,13 | H04B10/06<br>H03G3/20<br>G08C23/00<br>G08B13/183 |
| Y | GB-A-1 315 115 (THE PLESSEY COMPANY LIMITED)<br><br>* the whole document *<br>--- | 1-6,<br>8-11,13 | |
| Y | WO-A-8 802 159 (MAGYAR OPTIKAI MÜVEK)<br>* page 7, line 11 - line 18; figure 3 *<br><br>----- | 11 | |
| | | | **TECHNICAL FIELDS SEARCHED (Int. Cl.5 )**<br><br>G08C<br>G08B<br>H04B<br>H03F<br>H03G |

The present search report has been drawn up for all claims

| Place of search | Date of completion of the search | Examiner |
|---|---|---|
| THE HAGUE | 10 JANUARY 1992 | WANZEELE R.J. |